# EUROPÄISCHE PATENTANMELDUNG

(11) **EP 0 993 051 A2**
(43) Veröffentlichungstag der Anmeldung: **12.04.2000**
(21) Anmeldenummer: 99115876.7
(22) Anmeldetag: 12.08.1999
(51) Int. Cl.: H01L 31/042, H01L 31/05

(54) **Solargenerator mit reihenweise auf einem Traggestell befestigten Solarzellen**

(30) Priorität: 25.08.1998 DE 19838485
(71) Anmelder: Sturm, Hermann, Dipl.-Ing., 74223 Flein (DE)
(72) Erfinder: Sturm, Hermann, Dipl.-Ing., 74223 Flein (DE)

(57) **Zusammenfassung**

Die Erfindung betrifft einen Solargenerator mit reihenweise auf einem Traggestell befestigten Solarzellen. Solche Solargeneratoren werden in grossen Stückzahlen für Solarkraftwerke hoher Leistung benötigt. Die Erfindung stellt sich die Aufgabe,durch die in ihren Ansprüchen enthaltenen Konstruktionsmerkmale sowohl von der Materialseite als auch seitens des zum Bau benötigten Arbeitszeitaufwands her eine wesentliche Kosteneinsparung gegenüber dem bekannten Stand der Technik zu erreichen.

Erfindungsgemäss werden zum Grundaufbau der Traggestelle nur Tragrohre (2) , Querträger (3) und Profilträger (9) benötigt,die in sich jeweils gleich ausgebildet sind. Der Zusammenbau kann konstruktionsbedingt in kurzer Zeit erfolgen,wobei grösstenteils ungelernte Arbeitskräfte eingesetzt werden können.

Die Montage der Solarzellen (8) kann unter Verwendung der erfindungsgemässen Steckverbinder (10) sowie auch der ebenfalls zur Erfindung gehörenden Befestigungsklammern (20) ohne Zuhilfenahme von Werkzeugen erfolgen.

In ihrer Gesamtheit ist die Erfindung auf den Bau grosser Solarkraftwerke in entlegenen Gebieten,mit dem Einsatz ortsansässiger ungelernter Arbeitskräfte ausgelegt.

## Beschreibung

Die Erfindung betrifft einen Solargenerator mit reihenweise auf einem Traggestell befestigten Solarzellen,welche durch Steckverbinder miteinander elektrisch verbunden sind.

Solargeneratoren dieser Art sind dazu bestimmt,einzelne Solarzellen zu grösseren Baugruppen zusammenzufassen. Beim Bau von Solarkraftwerken werden diese Solargeneratoren in grösserer Anzahl eingesetzt. Ihre Aufstellung erfolgt zumeist in freiem Gelände und in Gebieten mit hoher Sonneneinstrahlung.
Für Solargeneratoren dieser Art sind Bauformen aus allgemeiner Praxis bekannt, bei denen als Träger für die Solarzellen Stahlgerüste in Rahmenbauweise dienen, welche mit vier oder mehr Tragsäulen mit dem Erdreich verbunden sind. Die Solarzellen werden dabei mechanisch durch Verschrauben befestigt, ihre elektrische Verbindung und Zusammenschaltung erfolgt in diesen Fällen durch Kabelverbindungen,wobei jede einzelne Solarzelle oder Solarzellenanordnung Kabelanschlüsse oder Schraubklemmenanschlüsse besitzt.
In der DE 31 11 969 wird in Verbindung mit der vorstehend beschriebenen Traggestellbauweise gezeigt,wie die elektrische Verbindung der Solarzellen untereinander durch Heranziehung der Trägerkonstruktionsteile als Stromleiter erreicht werden soll. Dies bedingt jedoch einen beträchtlichen Aufwand durch die dafür notwendige Isolierung der einzelnen Trägerelemente gegeneinander.

Beide vorgenannte Bauweisen haben folgende Nachteile:
der mechanische Aufbau der Traggerüste benötigt eine grössere Reihe voneinander verschiedener Bauelemente,dadurch ergeben sich hohe Herstell-und Montagekosten,ferner sind zum Bau ausgebildete Arbeitskräfte erforderlich. Die Einstellung der Solarzellenfläche entsprechend dem Sonnenstand ist nicht möglich. Eine Potentialtrennung des Solarzellenverbandes vom Erdpotential für Spannungen im Kilovoltbereich, wie dies bei Grossanlagen erforderlich ist, macht grosse Schwierigkeiten. Der Aufgabenstellung, wie sie beim Bau von Grossanlagen in entfernten Gebieten vorliegt. nämlich leichter Transport und einfache Montage durch zumeist ungeschulte Arbeitskräfte, werden sie nicht gerecht. Die elektrische Verbindung von Solarzellen durch Schraubverbindung über Bauteile der Tragkonstruktion ist unsicher wegen der unterschiedlichen thermischen Ausdehnungen derselben.

Die Erfindung stellt sich die Aufgabe,mit ihren aufeinander abgestimmten Massnahmen sowohl in technischer als auch in wirtschaftlicher Hinsicht wesentliche Verbesserungen zu erzielen. Durch vereinfachte Montage sollen Arbeitskräfte mit geringer Ausbildung eingesetzt werden können.

Diese Aufgaben werden erfindungsgemäss erreicht durch die Ausbildung des Traggestells in der Weise, dass auf einem zentral angeordneten Tragrohr rechtwinklig dazu verlaufende Querträger angeordnet sind,welche zur Aufnahme auf dem Tragrohr eine dem Rohrprofil entsprechende Öffnung besitzen und mit demselben fest verbunden sind und dass ferner auf der Oberseite dieser Querträger rechtwinklig zu denselben Profilträger zur Aufnahme der Solarzellen angebracht sind. Diese erfindungsgemässe Massnahme bringt den grossen Vorteil mit sich, dass zum Grundaufbau des Traggestells nur drei Bauelementearten notwendig sind,die dazu noch in ihrer Grundform dem normalen Fertigungsprogramm von Stahlwerken, namlich Rohren, Profileisen und Blechen entsprechen und nur einfache Zuschnittarbeiten wie z.B. Ablängen zu ihrer Anfertigung notwendig sind.
Gemäss der Erfindung bestehen die Querträger aus senkrecht stehenden Blechprofilen mit ober-und unterseitig gegensinnig ausgebildeten Abkantungen, wobei die oberseitigen Abkantungen zur Aufnahme der rechtwinklig dazu verlaufenden Profilträger dienen und mit diesen durch Punktschweissung fest verbunden sind.

Diese erfindungsgemässe Ausbildung der Querträger ergibt eine wesentliche Transporterleichterung,da die gegensinnige Abkantung eine vereinfachte Stapelung der Teile aufeinander zulässt. Unter Verwendung der vorstehend beschriebenen Massnahmen lässt sich unter Zuhilfenahme einer zweckentsprechenden Montageeinrichtung mit wenig ausgebildeten Arbeitskräften ein schnelles Zusammenbauen der Traggestelle erreichen.

Gemäss einer weiteren Ausbildung der Erfindung haben die Profilträger T-förmigen Querwobei ferner in dem senkrecht stehenden Mittelsteg derselben beiderseits nutförmige Ausnehmungen eingebracht sind,in welche zur Befestigung der Solarzellen dienende Befestigungsklammern eingerastet sind.
Diese erfindungsgemässe Massnahme erlaubt eine rasche und sichere Befestigung der Solarzellen ohne Zuhilfenahme von Werkzeug. Sie kann auch von ungeschulten Kräften durchgeführt werden. Weiterhin werden die geringen, jedoch bei Schraubverbindungen kritischen thermisch bdingten Ausdehnungsunterschiede von den federnden Befestigungsklammern aufgenommen. Ein weiterer Vorteil beim Auswechseln von Solarzellen ist die einfache Lösbarkeit dieser Verbindung.

Ein weiterer Bestandteil ist die Art der elektrischen Verbindung der Solarzellen, dadurch gekennzeichnet,dass die Solarzellen durch doppelseitig ausgebildete Kontaktelemente lösbar miteinander verbunden sind,welche auf flächig ausgebildeten Kontaktstellen der Solarzellen aufgesteckt sind. Weiterhin sind die beiden Kontaktteile der doppelseitig ausgebildeten Kontaktelemente durch Verbindungsleitungen miteinander verbunden.
Eine weitere Verbesserung ergibt sich erfindungsgemass dadurch, dass die beiden Kontaktteile der doppelseitig Kontaktelemente durch einen, die elastische Verbindung sicherstellenden Steg einstückig miteinander verbunden sind.

Die vorstehend geschilderten Massnahmen erlauben eine sichere und rasche elektrische Verbindung der einzelnen Solarzellen miteinander. Dieser Arbeitsgang des Aufsteckens der Kontaktteile fügt sich organisch in den Arbeitsablauf der Solarzellenmontage ein und kann auch von einfachen Arbeitskräften durchgeführt werden. Dazu kommen noch zwei weitere Vorteile: zum Einen werden alle Kräfte,die eine spätere mechanische Bewegung der Kontaktteile bewirken können, durch den elastischen Verbindungssteg aufgenommen, zum Zweiten erlaubt diese erfindungsgemässe Art der Steckverbindung ein leichtes Auswechseln ein zelner Solarzellen aus dem Gesamtverband heraus, dies durch das elastische Nachgeben der Verbindungsstege.

Die Aufständerung des Solargenerators ist erfindungsgemäss dadurch gekennzeichnet, dass hierzu zwei mit dem Erdreich verbundene Tragsäulen dienen, welche ein Kopfteil zur Aufnahme des Tragrohrs haben, wobei dieses Kopfteil zwei miteinander verbundene Halbschalen besitztwodurch eine drehbare Lagerung des Traggestells zur Einstellung auf die günstigste Stromausbeute möglich ist, und dass wahlweise durch die Einfügung einer auf das Tragrohr aufgeschobenen Isolierstoffhülse eine elektrische Trennung des Traggestells gegenüber dem Erdpotential ermöglicht wird.

Die gewerbliche Anwendung von Solargeneratoren gemäss der Erfindung liegt vor allem beim Bau grösserer Solarkraftwerke. Da sich aus technischen Gründen Solargeneratoren nur bis zu einer Solarleistung von ca. 100 Kilowatt bauen lassen, sind für Solarkraftwerke mit 1 000 Megawatt Leistung entsprechend der üblichen Grösse herkömmlicher Kraftwerke,eine grosse Anzahl einzelner Solargeneratoren erforderlich. Da der Preisanteil der Traggestellstruktur und der Montagearbeiten wesentlich an den Gestehungskosten eines Solarkraftwerkes beteiligt ist,sind Vereinfachungen an den Solargeneratoren sehr wesentlich.

Das Wesen der Erfindung wird an Hand von Zeichnungen näher erläutert.

Es zeigen:
- Fig. 1: eine perspektivische Darstellung des Traggestells
- Fig. 2: Ansichts und Schnittzeichnung eines Querträgers
- Fig. 3: ein doppelseitig ausgebildetes Kontaktelement in aufgestecktem Zustand in der Ansicht
- Fig. 4: ein solches in Schnittdarstellung
- Fig. 5: die Befestigung der Solarzellen in Schnittdarstellung
- Fig. 6: dasselbe in der Seitenansicht
- Fig. 7: den Austausch einer Solarzelle.

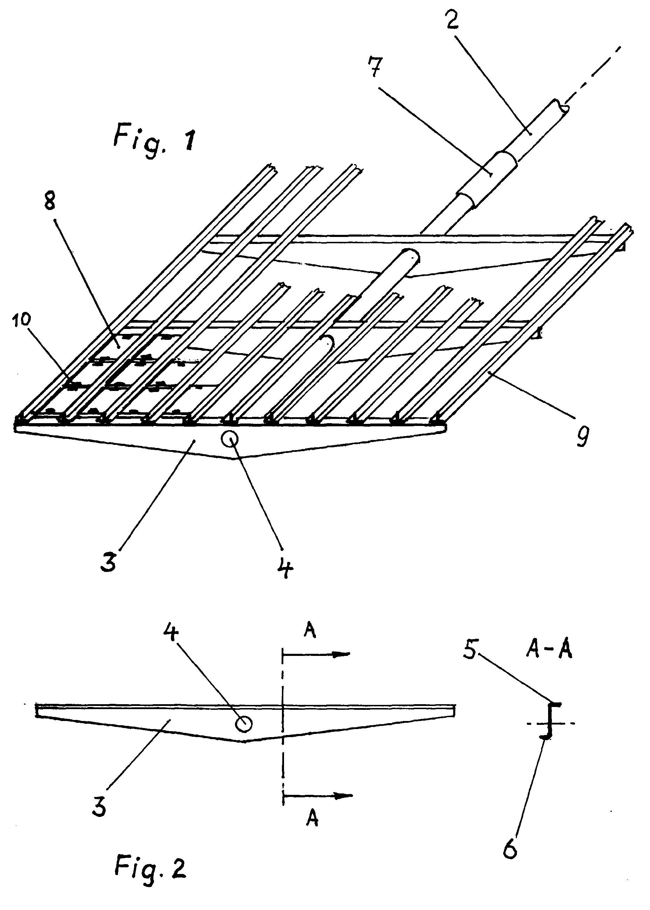

Fig. 1 zeigt in perspektivischer Teilansicht eine Ausführung des Traggestells 1 gemäss der Erfindung. Auf einem zentral angeordneten Tragrohr 2 sind Querträger 3 aufgeschoben, welche hierzu einen mittig angeordneten Durchbruch 4 besitzen. Im Gang der Montage werden alle vorgesehenen Querträger 3 ,evt. unter Einfügung zweier lsolierstoffhülsen 7,auf das Trägerrohr 1 aufgeschoben. Die Isolierstoffhülsen 7 dienen der Potentialtrennung zwischen dem Traggestell 1 mit den darauf befindlichen Solarzellen 8 und dem Erdpotential. Dadurch ist es möglich, bei jedem der Solargeneratoren einer Grossanlage die Solarzellenanordnung auf das Potential der Metallteile des Traggestells zu legen, um definierte und niedrige Spannungen zwischen diesen Teilen zu haben. Die Traggestelle selbst nehmen bei Grossanlagen hohe Spannungen gegen Erde an, da mit Rücksicht auf kleine Leitungsverluste mit hohen, nur durch Serienschaltung der Solargeneratoren erreichbaren Betriebsspannungen gearbeitet werden muss.
Im weiteren Verlauf der Montage des Traggestells werden in einer Montagevorrichtung die Querträger zueinander ausgerichtet, worauf die Verbindung mit dem Tragrohr 2 durch Verschweissen erfolgt. In Fig.2 ist ein solcher Querträger 3 in der Ansicht und im Schnitt dargestellt. Er hat Doppeltrapezform aus Festigkeitsgründen, wozu auch die beiden Abkantungen 5 und 6 beitragen. Die gegensinnige Abkantung erlaubt ein platzsparendes Stapeln, die Öffnung 4 ermöglicht das Aufschieben auf das Tragrohr 2. Die Herstellung erfolgt aus Stahlblech, durch wechselseitigen Zuschnitt ist eine fast abfalllose Fertigung möglich.
Anschliessend werden die zur Aufnahme der Solarzellen 8 dienenden, T-formigen Querschnitt aufweisenden Profilträger 9 auf die Oberseite der Querträger 3 unter Einhaltung des gegenseitigen Abstands aufgelegt und mit deren oberseitigen Abkantungen 5 vorzugsweise mittels Punktschweissung verbunden.
Auf die wagrecht verlaufenden Abschnitte der Profilträger 9 werden nun die Solarzellen 8 afgelegt, wobei durch Aufstecken der doppelseitig ausgebildeten Kontaktteile 10 auf die flächig ausgebildeten Kontaktstellen der Solarzellen 8 die elektrische Verbindung zwischen den aufeinander folgenden Solarzellen 8 erfolgt.

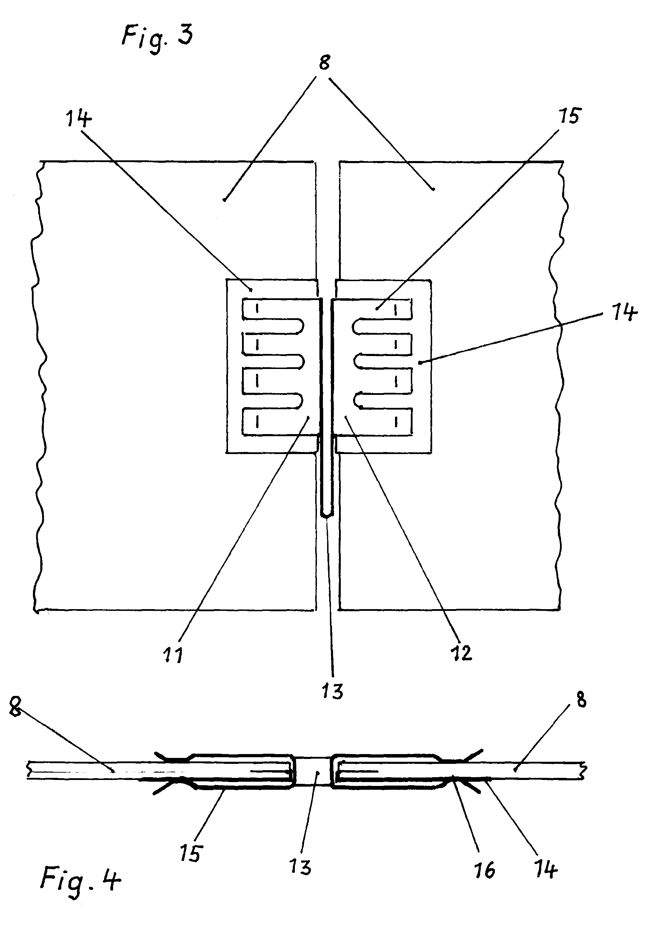

In Fig.3 ist ein solches erfindungsgemässes Kontaktteil 10 in aufgestecktem Zustand dargestellt, dazu dasselbe im Schnitt. Hierbei besitzen die Solarzellen 8, jeweils auf ihren Gegenseiten, Herausführungen der Stromanschlüsse Plus und Minus in Form einseitiger oder auch doppelseitiger flächig ausgebildeter Kntaktstellen 14. Auf diese werden die Kontaktteile 11 und 12 aufgesteckt, welche einseitig oder auch doppelseitig vorzugsweise mehrere für sich getrennt federnde Kontaktfinger 15 besitzen,um eine hohe Kontaktsicherheit zu erreichen. Eine aussermittige Anordnung der Kontaktflächen 14 stellt sicher, dass bei der Montage keine Fehipolungen auftreten können. Der elastische Verbindungssteg 13 hat dreierlei Funktion: zum einen die elektrische Verbindung der Kontaktteile 11 und 12, zum zweiten der Entlastung derselben von mechanischen Kräften, um eine Verschiebung der Kontaktstellen zu vermeiden, zum dritten wird durch seine elastische Nachgiebigkeit, verbunden mit ausreichender Länge, die einfache Austauschbarkeit einzelner Solarzellen 8 aus dem geschlossenen Verband heraus ermöglicht.
Sowohl die flächig ausgebildeten Kontaktstellen 14 der Solarzellen 8 als auch die Kontaktkuppen 16 der fedenden Kontaktfinger 15 sind mit einem geeigneten Kontaktwerkstoff wie beispielsweise Silber beschichtet. Da erfindungsgemäss infolge des federnd nachgiebigen Verbindungssteges 13 keine Verschiebungen an den Kontaktstellen auftreten können, ist auch der Einsatz anderer Werkstoffe möglich, welche in Verbindung mit ausreichend hohen Kontaktdrücken eine Kaltverschweissung an der Kontaktstelle ergeben. Damit wird eine gasdichte Verbindung mit hoher Sicherheit gegen Umwelteinflüsse erzielt.
Nach dem Herstellen der elektrischen Verbindung erfolgt im weiteren Verlauf der Montage die Befestigung der Solarzellen.

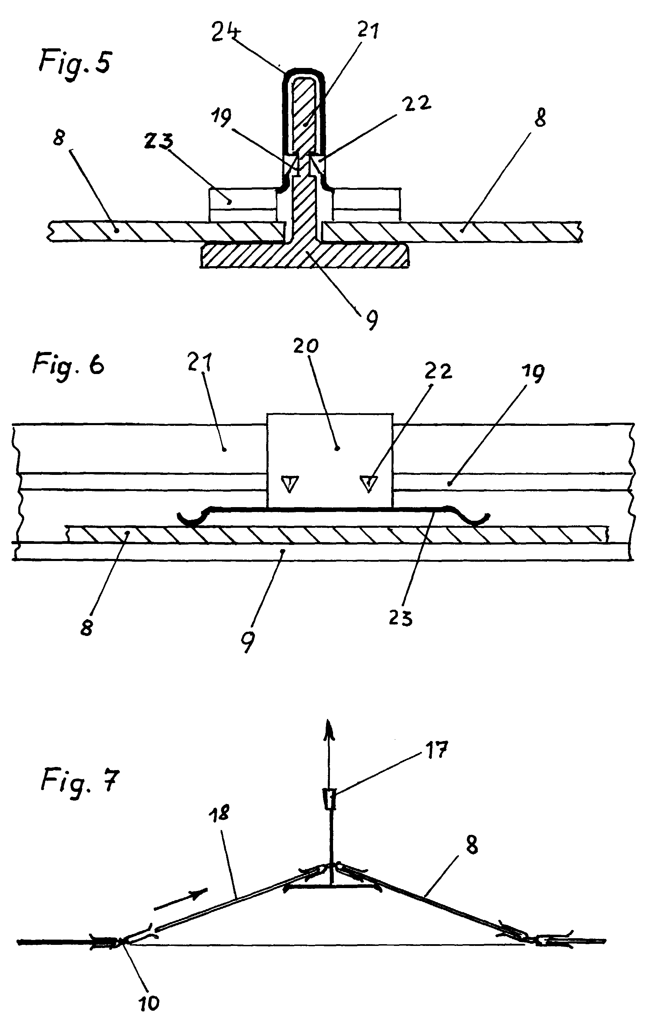

In Fig. 5 wird die erfindungsgemässe Art der Solarzellen Befestigung im Schnitt, in Fig. 6 in der Seitenansicht gezeigt. Dazu besitzen alle T-förmigen Profilträger 9 beiderseits des senkrechten Steges 21 Nuten 19, in welche Fixiernasen 22 der federnden Befestigungsklammer 20 beim Aufdrücken derselben auf den Steg 21 einrasten Die ihrerseits federnden Andruckzungen 23 bewirkendie Niederhaltung der Solarzelle 8 auf den Profilträgern 9 mit gleichmässigem und konstantem Druck. Die Entfernung der Befestigungsklammern 20 kann auf einfache Weise durch Aufspreizen des U-förmigen Federabschnitts 24 erfolgen.

In Fig. 7 ist dargestellt, wie gemäss der Erfindung einzelne Solarzellen
aus dem geschlossenen Verband heraus ausgetauscht werden können. Hierzu werden zunächst die Befestigungsklammern 20 entfernt. Darauf wird ein einfach ausgebildetes Werkzeug in den Zwischenraum bei der auszutauschenden Solarzelle 18 eingeschoben. Damit kann durch Anheben zunächst die eine, dann die andere Kontaktverbindung an der Solarzelle 18 gelöst und diese Solarzelle herausgenommen werden. Die Ersatzzelle wird dann in umgekehrter Reihenfolge eingesetzt.
Nach Fertigstellung der Solarzellenmontage kann das nunmehr komplettierte Traggestell mittels eines Kranwagens aus der Montageeinrichtung herausgehoben und zum Aufstellungsort transportiert werden. Dort erfolgt Absetzen und Befestigen desselben auf den vor bereiteten Tragsäulen. Der damit fertiggestellte Solargenerator wird dann auf die vorgesehene Winkelstellung der Solarzellenfläche zur Horizontalen eingestellt.

Für die Beurteilung der Patntfähigkeit in Betracht zu ziehende Druckschriften:
DE 31 11 969

## Patentansprüche

1. Solargenerator mit reihenweise auf einem Traggestell befestigten Solarzellen,welche durch Steckverbinder miteinander elektrisch verbunden sind,
gekennzeichnet durch ein Traggestell,das in der Form ausgebildet ist,dass auf einem zentral angeordneten Tragrohr rechtwinklig dazu verlaufende Querträger angeordnet sind, welche zur Aufnahme auf dem Tragrohr eine dem Rohrprofil entsprechende Öffnung besitzen und mit demselben fest verbunden sind und dass ferner auf der Oberseite dieser Querträger rechtwinklig zu denselben verlaufend Profilträger zur Aufnahme der Solarzellen angebracht sind.

2. Solargenerator nach Anspruch 1.
dadurch gekennzeichnet, dass die Querträger aus senkrecht stehenden Blechprofilen mit ober- und unterseitigen gegensinnig ausgebildeten Abkantungen bestehen,wobei die oberseitigen Abkantungen zur Aufnahme der rechtwinklig dazu verlaufenden Profilträger dienen und mit diesen vorzugsweise durch Punktschweissung verbunden sind.

3. Solargenerator nach den Ansprüchen 1 und 2,
dadurch gekennzeichnet, dass die Profilträger T-förmigen Querschnitt haben, dass ferner in dem senkrecht stehenden Mittelsteg der T-förmigen Profilträger beiderseits nutförmige Ausnehmungen eingebracht sind in welche zur Befestigung der Solarzellen dienende Befestigungsklammern eingerastet sind.

4. Solargenerator nach den Ansprüchen 1 bis 3,
dadurch gekennzeichnet,dass die Solarzellen elektrisch miteinander durch doppelseitig ausgebildete Kontaktelemente lösbar verbunden sind, welche auf flächig ausgebildeten Kontaktstellen der Solarzellen aufgesteckt sind.

5. Solargenerator nach den Ansprüchen 1 bis 4,
dadurch gekennzeichnet,dass die beiden Kontaktteile der doppelseitig ausgebildeten Kontaktelemente durch Verbindungsleitungen miteinander verbunden sind.

6. Solargenerator nach den Ansprüchen 1 bis 4,
dadurch gekennzeichnet,dass die beiden Kontaktteile der doppelseitig augebildeten Kontaktelemente durch einen die elektrische Verbindung bewirkenden elastischen Verbindungssteg einstückig miteinander verbunden sind.

7. Solargenerator nach den Ansprüchen 1 bis 6,
dadurch gekennzeichnet,dass zur Aufständerung des Traggestells zwei mit dem Erdreich verbundene Tragsäulen dienen, welche ein Kopfteil zur Aufnahme des Tragrohrs haben wobei dieses Kopfteil zwei miteinander verbundene Halbschalen besitzt, wodurch eine drehbare Lagerung des Traggestells zur Einstellung auf die günstigste Stromausbeute möglich ist, und dass wahlweise durch die Einfügung einer auf das Tragrohr aufgeschobenen Isolierstoffhülse eine elektrische Trennung des Traggestells gegenüber dem Erdpotential ermöglicht wird.
